# EUROPÄISCHE PATENTSCHRIFT

(11) **EP 3 839 106 B1**
(45) Veröffentlichungstag und Bekanntmachung des Hinweises auf die Patenterteilung: **15.05.2024**
(21) Anmeldenummer: 20000463.8
(22) Anmeldetag: 11.12.2020
(51) Int. Cl.: C30B 25/16, C30B 29/40, C30B 29/42, H01L 21/02

(54) **GASPHASENEPITAXIEVERFAHREN**
GAS PHASE EPITAXY METHOD
PROCÉDÉ D'ÉPITAXIE EN PHASE GAZEUSE

(30) Priorität: 20.12.2019 DE 102019008927
(43) Veröffentlichungstag der Anmeldung: 23.06.2021
(73) Patentinhaber: AZUR SPACE Solar Power GmbH, 74072 Heilbronn (DE)
(72) Erfinder: Wächter, Clemens, 74348 Lauffen am Neckar (DE); Keller, Gregor, 74080 Heilbronn (DE); Wierzkowski, Thorsten, 74074 Heilbronn (DE); Fuhrmann, Daniel, 74081 Heilbronn (DE)
(74) Vertreter: Koch Müller Patentanwaltsgesellschaft mbH

(56) Entgegenhaltungen:
- US-A- 3 224 913
- US-A- 3 419 742
- US-A1- 2014 120 703

## Beschreibung

Es sind die unterschiedlichsten Gasphasenepitaxie-Anlagen, z.B. von der Fa. Aixtron, zum epitaktischen Erzeugen von Halbleiterschichten bekannt.

Den Anlagen gemein ist, dass die epitaktischen Schichten aus der Gasphase auf einem in einer Reaktionskammer eingebrachten Substrat abgeschieden bzw. aufgewachsen werden. Hierzu wird die Reaktionskammer aufgeheizt und ein Epitaxie-Gasfluss in die Reaktionskammer eingeleitet.

Die Zusammensetzung des Gasflusses richtet sich nach der Art der zu wachsenden Schicht, wobei typischerweise Präkursoren, wie z.B. Arsin und / oder TMGa, die Elemente für die zu wachsende Halbleiterschicht liefern und für eine Dotierung der Schicht gegebenenfalls auch Präkursoren für einen Dotierstoff zugegeben werden. Die Präkursoren werden mittels eines Trägergases in die Reaktionskammer geleitet. Um die Zusammensetzung des Gasflusses zu kontrollieren werden typischerweise Massestromregler eingesetzt.

Zu beachten ist allerdings auch, dass aufgrund der Reaktorhistorie auch noch andere unerwünschte Elemente aus vorherigen Prozessen in der Reaktionskammer vorhanden sein können. Gerade für das Erzeugen niedrig dotierter Schichten kann dies problematisch werden. Aus der US 2014/120703 A1, der US 3 224 913 A und der US 3 419 742 sind weitere Epitaxieverfahren bekannt.

Vor diesem Hintergrund besteht die Aufgabe der Erfindung darin, ein Verfahren anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Gasphasenepitaxieverfahren bereitgestellt, aufweisend den Verfahrensschritt Aufwachsen einer III-V-Schicht mit einem sich von einer n-Dotierung zu einer p-Dotierung ändernden Dotierungsverlauf auf einer Oberfläche eines Substrats oder einer vorausgehenden Schicht in einer Reaktionskammer aus der Gasphase aus einem mindestens ein Trägergas umfassenden Epitaxie-Gasflusses.

In dem Verfahrensschritt Aufwachsen wird mit dem Trägergas ein erster Präkursor für ein erstes Element aus der III. Hauptgruppe und mindestens ein zweiter Präkursor für ein erstes Element aus der V. Hauptgruppe in die Reaktionskammer der Epitaxie- vorzugsweise MOCVD Anlage geleitet.

Bei Erreichen einer ersten Aufwachshöhe wird in dem Epitaxie-Gasfluss ein n-Dotierungsausgangswert mittels eines zu einer p-Dotierung führenden Verhältnisses eines ersten Massestroms des ersten Präkursors zu einem zweiten Massestrom des zweiten Präkursor und unter Zugabe eines dritten Massestroms eines für einen n-Dotierstoff dritten Präkursors eingestellt.

Anschließend wird der dritte Massestrom und / oder das Verhältnis zwischen dem ersten Massestrom und dem zweiten Massestrom bei einer Übergangsbereichsschicht mit einer Aufwachshöhe von mindestens 10 µm schrittweise oder kontinuierlich bis zu einem Erreichen eines p-Dotierungszielwerts verändert.

Es versteht sich, dass eine III-V-Schicht mindestens eine Komponente oder auch mehrere Komponenten der III. Hauptgruppe, z.B. Aluminium oder Gallium und mindestens eine Komponente oder mehrere Komponenten der V. Hauptgruppe, z.B. Indium oder Arsen oder Phosphor aufweist.

Als Präkursor werden Moleküle bezeichnet, welche als Ausgangsprodukt für das epitaktische Wachstum dienen. Ein für das Wachstum einer Schicht geeigneter Präkursor ist entsprechend Molekül, bestehend aus einem aufzuwachsenden Element, z.B. einem Element der III. oder V. Hauptgruppe oder einem Dotierstoff, und mindestens einem weiteren Element.

Insbesondere bei metallorganischen Präkursoren, z.B. TMGa, ist mindestens ein weiteres Element Kohlenstoff, welcher während des Aufwachsens freigesetzt wird und als Dotierstoff wirkt.

Wird ein Präkursor für einen Dotierstoff zugefügt, so wird vorliegend von direkter Dotierung gesprochen, während ein Dotieren mittels des Kohlenstoffs eines für das Schichtwachstum verantwortlicher metallorganischen Präkursors als Autodoping bezeichnet wird.

Die Höhe sowie die Art der Dotierung einer III-V-Schicht ist auch von dem Mengenverhältnis zwischen dem Element der III. Hauptgruppe und dem Element der V. Hauptgruppe in der Reaktionskammer abhängig.

Je nach Art und Größe der verwendeten Gasphasen-Anlage schwankt das Mengenverhältnis innerhalb der Reaktionskammer, d.h. an unterschiedlichen Orten weist der ankommende Gasfluss unterschiedliche V-III-Mengenverhältnisse auf. Derartige Schwankungen können im Bereich eines einzelnen Substrats und / oder über mehrere Substrate hinweg auftreten.

Erfindungsgemäß wird das Mengenverhältnis zwischen den Elementen der III. und V. Hauptgruppe, also das Verhältnis eines ersten Massestroms des ersten Präkursors zu einem zweiten Massestrom des zweiten Präkursor in dem Epitaxie-Gasfluss so eingestellt, dass es in Abwesenheit eines dritten Präkursors für einen n-Dotierstoff, allein aufgrund des Kohlenstoffs des metallorganischen ersten Präkursors zu einer p-Dotierung der III-V-Schicht führen würde.

Ein n-Dotierungsausgangswert wird dann über die Zugabe eines ausreichenden Massestroms des dritten Präkursors für die n-Dotierung, z.B. Silan, eingestellt.

Es versteht sich, dass das Ändern des Massestroms oder das Ändern des Verhältnisses von zwei unterschiedlichen Masseströmen äquivalent mit dem Ändern eines entsprechenden Partialdrucks bzw. Partialdruckverhältnisses bzw. grundsätzlich äquivalent mit einer Mengenkontrolle/-änderung ist.

Es versteht sich auch, dass das Einstellen der genannten Dotierungswerte während des Aufwachsens geschieht bzw. dass durchgehend aufgewachsen wird und während des Wachsens bzw. Abscheidens die Masseströme geändert werden.

Der p-Dotierungszielwert wird anschließend über eine Rampe oder Treppe, also eine kontinuierliche oder schrittweise Reduktion der n-Dotierung in der aufwachsenden Schicht erreicht.

Die Änderung der Dotierung der zu wachsenden Schicht wird ausschließlich durch eine Reduktion des Massenstroms des dritten Präkursors, z.B. Silan, bewirkt. Anders ausgedrückt, die Zuführung des n-Dotierungsstoffes mittels des dritten Präkursors wird bis auf null reduziert. Hierdurch bewirkt das Autodoping durch das V/III Verhältnis eine p-Dotierung der aufzuwachsenden Schicht.

Ein Vorzug dieser Ausgestaltung besteht darin, dass das Gasphasenepitaxieverfahren unter Nutzung eines geringen Flusses des zweiten Präkursors für die Gruppe V durchführen lässt. Insbesondere wird für den zweiten Präkursor Arsin oder TGMa verwendet lassen sich mittels eines geringen Flusses des zweiten Präkursors die Herstellungskosten deutlich senken und die Umweltfreundlichkeit des Herstellungsprozesses stark erhöhen.

Wird oder ist beispielsweise ausgehend vom dem n-Dotierungsausgangswert ein dem p-Dotierungszielwert entsprechendes Mengenverhältnis zwischen Elementen der III. Hauptgruppe und V. Hauptgruppe gewählt und beibehalten, so wird anschließend der Massestrom des dritten Präkursors schrittweise oder kontinuierlich bei dem Wachsen der Übergangsbereichsschicht bis auf null reduziert. Hierdurch lässt sich die Höhe der p-Dotierung von dem Autodoping durch das V / III Verhältnis bestimmen.

In einer Weiterbildung wird nach dem Zudrehen des dritten Präkursors zusätzlich das Mengenverhältnis zwischen den Elementen der III. Hauptgruppe und V. Hauptgruppe geändert, um den p-Dotierungszielwert zu erreichen.

Gemäß einer weiteren Alternativen wird die Änderung der Dotierung über die Übergangsbereichsschicht allein durch eine Änderung des Mengenverhältnisses zwischen den Elementen der III. und V. Hauptgruppe bewirkt. Hierbei ist zuvor bereits der Massestrom des dritten Präkursors, d.h. vor einer Änderung der V / III Verhältnisses, auf null reduziert.

Als Trägergas für den Epitaxie-Gasfluss eignet sich beispielsweise H₂ oder N₂.

Durch die schrittweise oder kontinuierliche Änderung des Masseflusses des dritten Präkursors während des Wachsens der Übergangsbereichsschicht lässt sich ein reproduzierbarer Verlauf im Bereich des p-n Übergangs erzielen. Eine unerwünschte Ausbildung von seriellen mehrfach p/n Übergängen lassen sich auf den Halbleiterscheiben ebenso wie eine Ausbildung von lokalen Unterschieden in den Dotierstoffverläufen zuverlässig unterdrücken. Ein Weiterer Vorteil ist, dass sich eine Krosskontamination, beispielsweise aus der Belegung der Reaktorkammer aus vorangegangenen Epitaxiephasen, zuverlässig und wirkungsvoll kompensieren lässt und sich Schichten mit niedrigen Dotierungen unterhalb von 5•10¹⁵ cm⁻³ und insbesondere p / n Übergänge ausgehend von einer n-Dotierung zuverlässig herstellen lassen.

Ausgehend von einem konstanten V / III Verhältnisses während des Wachsens der Übergangsbereichsschicht von wenigstens 10 µm, lassen sich die bisherigen auf den Halbleiterscheiben stark schwankenden Sperrspannungen, mit Unterschieden von mehr als 20 V oder mehr als 100 V, reduzieren.

Insbesondere Schwankungen des V-III-Verhältnisses über die Halbleiterscheibe resultieren in unterschiedlichen lokalen Dotierungen und wirken sich gerade bei niedrigen Dotierungen besonders stark aus. Anders ausgedrückt, lokale Dotierungsunterschiede auf der Halbleiterscheibe bedingt durch Schwankungen des V / III Verhältnisses und / oder bedingt durch unterschiedliche Hintergrunddotierungen in der Epitaxie-Anlage werden reduziert.

Aufgrund von örtlichen Unterschieden im V-III-Verhältnis und/oder von Hintergrunddotierungen kann ein sprunghafter p-n Übergang, also eine Änderung der Dotierung von n nach p ohne Zwischenschritte und über eine sehr geringe Aufwachshöhe, z.B. höchstens einige Nanometer, gerade bei niedrigen Dotierungen zu sehr unterschiedlichen Sperrspannungen über einzelne Halbleiterscheiben und/oder mehrere Halbleiterscheiben hinweg führen.

Ein Vorzug des Verfahrens besteht darin, dass sich das Gasphasenepitaxieverfahren unter Nutzung eines geringen Flusses des zweiten Präkursors für die Gruppe V durchführen lässt. Wird insbesondere für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Durch die schrittweise oder kontinuierliche Änderung der Dotierung über die Dicke einer Übergangsbereichsschicht bei einem konstanten oder nahezu konstanten V/III Verhältnis der Masseströme, wird dagegen ein über die gesamte Reaktionskammer hinweg reproduzierbarer Verlauf des p-n Übergangs erreicht auf der Halbleiterscheiber erreicht.

Die Unterschiede im ankommenden Gasfluss wirken sich lediglich auf die absolute Wachstumstiefe des Übergangs aus, wobei die Unterschiede in der absolute Wachstumstiefe eine geringeren Einfluss auf die erreichten Sperrspannungen als ein nicht reproduzierbarer Dotierungsverlauf des p-n Übergangs.

Ein weiterer Vorteil der Erfindung ist, dass sich auf einfache und reproduzierbare Weise ohne besondere zusätzliche Reinigungsschritte an den verwendeten Gasphasen-Epitaxie-Anlagen, zuverlässig hohe Spannungsfestigkeiten oberhalb von 200 V erreichen lassen.

In einer Ausführungsform beträgt der n-Dotierungsausgangswert höchstens 1•10¹⁶ cm⁻³ oder höchstens 1•10¹⁵ cm⁻³ oder höchstens 5•10¹⁴ cm⁻³.

In einer weiteren Ausführungsform beträgt der p-Dotierungszielwert höchstens 5•10¹⁵ cm⁻³ oder höchstens 1•10¹⁵ cm⁻³ oder höchstens 7•10¹⁴ cm⁻³.

Gemäß einer anderen Ausführungsform wird nach dem Erreichen des p-Dotierungszielwerts über eine Aufwachshöhe von mindestens 10 µm mit den Einstellungen für den p-Dotierungszielwert weiter aufgewachsen.

In einer alternativen Ausführungsform wird nach dem Erreichen des p-Dotierungszielwerts durch Ändern des dritten Massestroms und/oder durch Ändern des Verhältnisses zwischen dem ersten und zweiten Massestrom einen zweiten p-Dotierungszielwert eingestellt, wobei der zweite p-Dotierungszielwert größer als der p-Dotierungszielwert ist.

Gemäß einer Weiterbildung beträgt die Aufwachshöhe der Übergangsbereichsschicht mindestens 30 µm oder mindestens 60 µm.

In einer anderen Weiterbildung wird die Dotierung über die Übergangsbereichsschicht in Schritten von höchstens 1•10¹³ cm⁻³ über 5 µm geändert.

Gemäß einer weiteren Ausführungsform wird die Dotierung über die Übergangsbereichsschicht in mindestens vier Schritten geändert.

In einer anderen Ausführungsform wird nach dem Erreichen des n-Dotierungsausgangswert und vor dem Aufwachsen der Übergangsbereichsschicht der n-Dotierungsausgangswert durch Reduktion des dritten Massestroms in dem Epitaxie-Gasfluss sprunghaft auf einen zweiten n-Dotierungsausgangswert gesenkt oder sprunghaft auf einen p-Dotierungsausgangswert von höchstens 1•10¹⁵ cm⁻³ oder höchstens 5•10¹⁴ cm⁻³ eingestellt.

Gemäß einer weiteren Weiterbildung ist der dritte Präkursor Monosilan.

In einer weiteren Ausführungsform ist das Element der III. Hauptgruppe Gallium und das Element der V. Hauptgruppe Arsen.

In einer Weiterbildung wird nach dem Erreichen des Dotierungszielwerts über eine Aufwachshöhe ein zweiter p-Dotierungszielwert durch sprunghaftes Ändern des dritten Massestroms und/oder durch sprunghaftes Ändern des Verhältnisses des ersten Massestroms zu dem zweiten Massestrom eingestellt, wobei der zweite p-Dotierungszielwert größer als der n-Dotierungszielwert ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: einen Querschnitt von in einer Reaktionskammer angeordneten Substraten,
- Figur 2: ein Zusammenhang zwischen einer Dotierung und einem Verhältnis von Elementen der V. Hauptgruppe zu Elementen der III. Hauptgruppe während eines epitaktischen Wachstums,
- Figur 3: einen Dotierstoffkonzentrationsverlauf über eine gewachsene III-V-Schicht gemäß einer ersten erfindungsgemäßen Ausführungsform des Gasphasenepitaxieverfahrens,
- Figur 4: einen Dotierstoffkonzentrationsverlauf über eine gewachsene III-V-Schicht gemäß einer zweiten erfindungsgemäßen Ausführungsform des Gasphasenepitaxieverfahrens,
- Figur 5: Verlauf des Masseflusses des dritten Präkursors über die Aufwachshöhe,

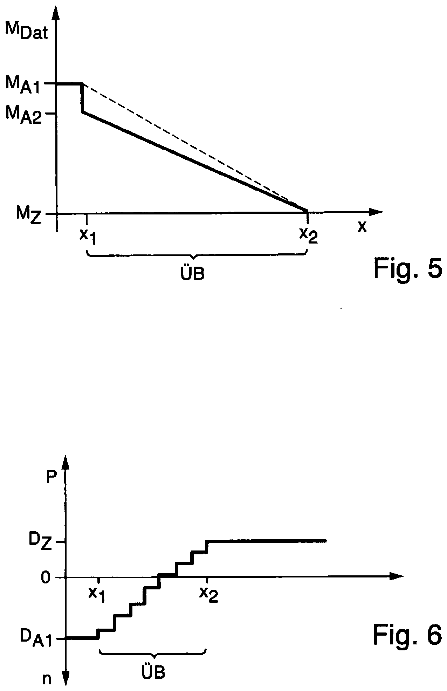

- Figur 5: einen Dotierstoffkonzentrationsverlauf über eine gewachsene III-V-Schicht gemäß einer dritten erfindungsgemäßen Ausführungsform des Gasphasenepitaxieverfahrens.

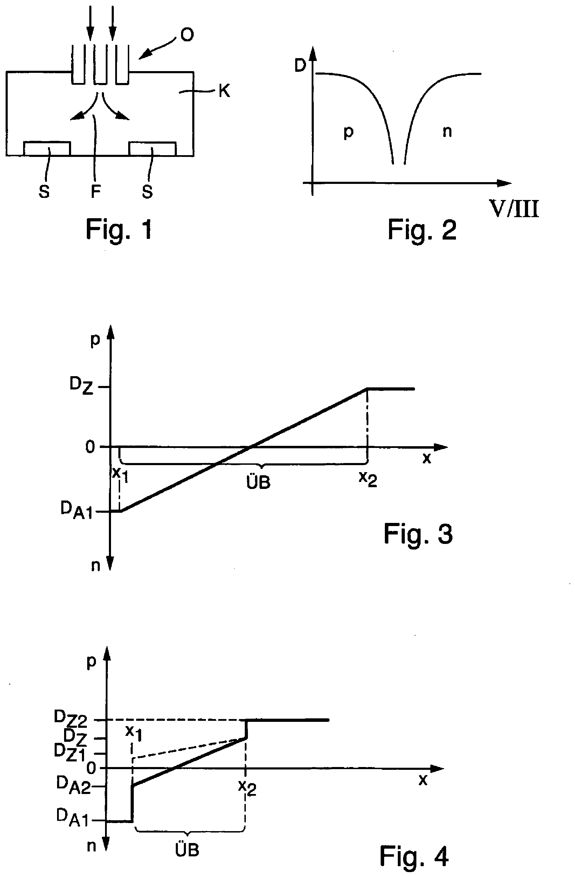

Die Abbildung der Figur 1 zeigt schematisch einen Querschnitt einer Reaktorkammer K einer Gasphasenepitaxie-Anlage. Auf einem Boden der Reaktorkammer K sind Substrate S angeordnet. Außerdem weist die Reaktorkammer K ein Gaseinlassorgan O auf, durch welches der Epitaxie-Gasfluss F in die Reaktorkammer K eingeleitet werden.

Der Epitaxie-Gasfluss F weist ein Trägergas, mindestens einen ersten metallorganischen Präkursor für ein Element der III. Hauptgruppe, z.B. TMGa, einen zweiten Präkursor für ein Element der V. Hauptgruppe, z.B. Arsin, und einen dritten Präkursor für einen n-Dotierstoff, z.B. Silan, auf.

Das Gaseinlassorgan O weist mehrere in der Reaktorkammer K endende Leitungen auf, durch welche jeweils eine Komponente oder mehrere Komponenten des Epitaxie-Gasflusses F zu der Reaktorkammer K geleitet werden.

In der Abbildung der Figur 2 ist in einem Diagramm die Abhängigkeit der Dotierung von einem Mengenverhältnis der Elemente der V. und III. Hauptgruppe auf. Insbesondere wird deutlich, dass sich nicht nur die Höhe einer Dotierung, sondern auch die Art der Dotierung, also n oder p, durch das V-III-Verhältnis einstellen lässt.

Andererseits wird deutlich, dass Schwankungen des V-III-Verhältnisses über eine Halbleiterscheibe bzw. ein Substrat zu unterschiedlichen Dotierungen führt und dass sich solche Schwankungen gerade bei niedrigen Dotierungen besonders stark auswirken, indem sich die Dotierung unerwünscht zwischen p und n wechselt.

Ein Vorzug dieser Ausgestaltung besteht darin, dass vorzugsweise das Gasphasenepitaxieverfahren unter Nutzung eines geringen Flusses des zweiten Präkursors für die Gruppe V durchführen lässt. Insbesondere wird für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Eine erste Ausführungsform des erfindungsgemäßen Gasphasenepitaxieverfahrens ist in der Abbildung der Figur 3 anhand eines Verlaufs der Dotierung D von n über null nach p über eine Aufwachshöhe x veranschaulicht.

Zuerst bzw. bei einer ersten Aufwachshöhe x₁ wird ein n-Dotierungsausgangswert D_{A1} mittels eines zu einer p-Dotierung führenden Verhältnisses eines ersten Massestroms des ersten Präkursors, z.B. TMGa, zu einem zweiten Massestrom des zweiten Präkursor, z.B. Arsin, in dem Epitaxie-Gasfluss F (linker Teil der Kurve der Figur 2) und unter Zugabe eines dritten Massestroms eines dritten Präkursors für einen n-Dotierstoff, z.B. Silan, zu dem Epitaxie-Gasfluss F eingestellt.

Anschließend wird der dritte Massestrom des dritten Präkursors kontinuierlich während des Aufwachsens eines Übergangsbereichsschichts ÜB reduziert, bis ein p-Dotierungszielwert D_{z} bei der Schichtdicke x₂ erreicht ist. Es versteht sich, dass die Übergangsbereichsschicht ÜB von dem Wert x₁ bis zu dem Wert x₂ erstreckt.

Anschließend wird der Epitaxie-Gasfluss über einen weiteren Bereich der Aufwachshöhe x nicht weiter verändert, so dass die Dotierung der sich anschließenden III-V-Schicht konstant bleibt.

Alternativ und in der Figur 3 gestrichelt dargestellt wird der dritte Massestrom ausgehend von dem n-Dotierungsausgangswert D_{A1} sprunghaft bis auf einen p-Dotierungsausgangswert D_{A2*} von höchstens 1•10¹⁵ cm⁻³ oder höchstens 5•10¹⁴ cm⁻³ reduziert, bevor die Dotierung in Form einer Rampe bis zu dem p-Dotierungszielwerts D_{Z} geändert wird.

Nach Erreichen des p-Dotierungszielwerts D_{Z} wird die Dotierung durch Ändern des dritten Masseflusses M_{Dot} und/oder der Verhältnisses zwischen dem ersten und zweiten Massefluss nochmals sprunghaft auf einen zweiten p-Dotierungszielwert D_{Z2} erhöht und anschließend ohne weitere Änderungen an dem Epitaxie-Gasfluss eine Schicht mit konstanter p-Dotierung aufgewachsen.

In der Abbildung der Figur 4 ist eine weitere Ausführungsform des erfindungsgemäßen Gasphasenepitaxieverfahrens anhand des Dotierungsverlaufs D veranschaulicht, wobei im Folgenden nur die Unterschiede zu der Abbildung der Figur 3 erläutert werden.

Ausgehend von dem n-Dotierungsausgangswert D_{A1} wird die Dotierung durch Reduktion des dritten Massestroms in dem Epitaxie-Gasfluss F sprunghaft auf einen zweiten n-Dotierungsausgangswert D_{A2} gesenkt, bevor die Dotierung über die Übergangsbereichsschicht ÜB kontinuierlich oder schrittweise bis zu dem Erreichen des p-Dotierungszielwerts D_{Z} geändert wird.

In der Abbildung der Figur 5 ist eine weitere Ausführungsform des erfindungsgemäßen Gasphasenepitaxieverfahrens anhand eines Verlaufs des dritten Massestroms M_{Dot} des dritten Präkursors für den n-Dotierstoff veranschaulicht.

Ausgehend von einem Massestromausgangswert M_{A1} zum Erreichen des n-Dotierungsausgangswerts D_{A1} wird der dritte Massestrom M_{Dot} sprunghaft reduziert, so dass sich ein zweiter Massestromausgangswert M_{A2} und dadurch auch eine sprunghaft reduzierte Dotierung eingestellt.

Anschließend wird der dritte Massestrom M_{Dot} kontinuierlich bis auf null reduziert, wodurch die rampenförmige Änderung der Dotierung bis auf den p-Dotierungszielwert D_{Z} ergibt.

In der Abbildung der Figur 6 ist eine weitere Ausführungsform des erfindungsgemäßen Gasphasenepitaxieverfahrens anhand des Dotierungsverlaufs D veranschaulicht, wobei im Folgenden nur die Unterschiede zu den Abbildungen der Figuren 3 und 4 erläutert werden.

Die Änderung der Dotierung von dem n-Dotierungsausgangswert D_{A1} zu dem p-Dotierungszielwert D_{Z} erfolgt in mehreren Schritten, so dass sich ein treppenförmiger Verlauf der Dotierung über die Übergangsbereichsschicht ÜB einstellt.

## Patentansprüche

1. Gasphasenepitaxieverfahren mit dem Verfahrensschritt:
- Aufwachsen einer III-V-Schicht mit einem sich von einer n-Dotierung zu einer p-Dotierung ändernden Dotierungsverlauf auf einer Oberfläche eines Substrats (S) oder einer vorausgehenden Schicht in einer Reaktionskammer (K) aus der Gasphase aus einem Epitaxie-Gasfluss (F) aufweisend ein Trägergas, mindestens einen ersten Präkursor für ein erstes Element aus der III. Hauptgruppe und mindestens einen zweiten Präkursor für ein erstes Element aus der V. Hauptgruppe, wobei
- bei Erreichen einer ersten Aufwachshöhe (x₁) ein n-Dotierungsausgangswert (D_{A1}) mittels eines zu einer p-Dotierung führenden Verhältnisses eines ersten Massestroms des ersten Präkursors zu einem zweiten Massestrom des zweiten Präkursor in dem Epitaxie-Gasfluss (F) und unter Zugabe eines dritten Massestroms (M_{Dot}) eines dritten Präkursors für einen n-Dotierstoff zu dem Epitaxie-Gasfluss (F) eingestellt wird,
- anschließend der dritte Massestrom (M_{Dot}) und/oder das Verhältnis zwischen dem ersten und zweiten Massestrom über eine Übergangsbereichsschicht (ÜB) mit einer Aufwachshöhe (x) von mindestens 10 µm treppenförmig oder kontinuierlich bis zu einem Erreichen eines p-Dotierungszielwerts (D_{Z}) verändert wird.

2. Gasphasenepitaxieverfahren nach Anspruch 1, **dadurch gekennzeichnet, dass** der n-Dotierungsausgangswert (D_{A1}) höchstens 1•10¹⁶ cm⁻³ oder höchstens 1•10¹⁵ cm⁻³ oder höchstens 5•10¹⁴ cm⁻³ beträgt.

3. Gasphasenepitaxieverfahren nach einem der vorstehenden Ansprüche, **dadurch gekennzeichnet, dass** der p-Dotierungszielwert (D_{Z}) höchstens 5•10¹⁵ cm⁻³ oder höchstens 1•10¹⁵ cm⁻³ beträgt.

4. Gasphasenepitaxieverfahren nach einem der vorstehenden Ansprüche, **dadurch gekennzeichnet, dass** nach dem Erreichen des p-Dotierungszielwerts (D_{Z}) über eine Aufwachshöhe (x) von mindestens 10 µm mit den Einstellungen für den p-Dotierungszielwert (D_{Z}) weiter aufgewachsen wird.

5. Gasphasenepitaxieverfahren nach einem der vorstehenden Ansprüche, **dadurch gekennzeichnet, dass** nach dem Erreichen des p-Dotierungszielwerts (D_{Z}) durch Ändern des dritten Massestrom (M_{Dot}) und/oder durch Ändern des Verhältnisses zwischen dem ersten und zweiten Massestrom ein zweiten p-Dotierungszielwert (D_{Z2}) eingestellt wird, wobei der zweite p-Dotierungszielwert (D_{Z2}) größer als der p-Dotierungszielwert (D_{Z}) ist.

6. Gasphasenepitaxieverfahren nach einem der vorstehenden Ansprüche, **dadurch gekennzeichnet, dass** die Aufwachshöhe (x) der Übergangsbereichsschicht (ÜB) mindestens 30 µm oder mindestens 60 µm beträgt.

7. Gasphasenepitaxieverfahren nach einem der vorstehenden Ansprüche, **dadurch gekennzeichnet, dass** die Dotierung (D) über die Übergangsbereichsschicht (ÜB) in Schritten von höchstens 1•10¹³ cm⁻³ über 5 µm geändert wird.

8. Gasphasenepitaxieverfahren nach einem der vorstehenden Ansprüche, **dadurch gekennzeichnet, dass** die Dotierung (D) über die Übergangsbereichsschicht (ÜB) in mindestens vier Schritten geändert wird.

9. Gasphasenepitaxieverfahren nach einem der vorstehenden Ansprüche, **dadurch gekennzeichnet**, nach dem Erreichen des n-Dotierungsausgangswert (D_{A1}) und vor dem Aufwachsen der Übergangsbereichsschicht (ÜB) der n-Dotierungsausgangswert (D_{A1}) durch Reduktion des dritten Massestroms (M_{Dot}) in dem Epitaxie-Gasfluss (F) sprunghaft auf einen zweiten n-Dotierungsausgangswert (D_{A2}) gesenkt oder sprunghaft auf einen p-Dotierungsausgangswert (D_{A2*}) von höchstens 1•10¹⁵ cm⁻³ oder höchstens 5•10¹⁴ cm⁻³ eingestellt wird.

10. Gasphasenepitaxieverfahren nach einem der vorstehenden Ansprüche, **dadurch gekennzeichnet, dass** der dritte Präkursor Monosilan ist.

11. Gasphasenepitaxieverfahren nach einem der vorstehenden Ansprüche, **dadurch gekennzeichnet, dass** das Element der III. Hauptgruppe Gallium und das Element der V. Hauptgruppe Arsen ist.

12. Gasphasenepitaxieverfahren nach einem der vorstehenden Ansprüche, **dadurch gekennzeichnet, dass** nach dem Erreichen des Dotierungszielwerts (DZ) über eine Aufwachshöhe ein zweiter p-Dotierungszielwert (DZ2) durch sprunghaftes Ändern des dritten Massestroms und/oder durch sprunghaftes Ändern des Verhältnisses des ersten Massestroms zu dem zweiten Massestrom eingestellt wird, wobei der zweite p-Dotierungszielwert (DZ2) größer als der n-Dotierungszielwert (DZ) ist.

## Claims

1. Gas phase epitaxy method comprising the method step:
- growing a III-V layer comprising a course of doping, which changes from an n-doping to a p-doping, on a surface of a substrate (S) or a preceding layer in a reaction chamber (K) from the gas phase of an epitaxy gas flow (F) comprising a carrier gas, at least one first precursor for a first element from the III main group and at least one second precursor for a first element from the V main group, wherein
- on attainment of a first growth height (x₁) an n-doping start value (D_{A1}) is set by means of a ratio, which leads to p-doping, of a first mass flow of the first precursor to a second mass flow of the second precursor in the epitaxy gas flow (F) and with addition of a third mass flow (M_{Dot}) of a third precursor for an n-doping substance to the epitaxy gas flow (F),
- subsequently the third mass flow (M_{Dot}) and/or the ratio between the first and second mass flows is changed across a transitional region layer (ÜB) with a growth height (x) of at least 10 µm in steps or continuously until attainment of a p-doping target value (D_{Z}).

2. Gas phase epitaxy method according to claim 1, **characterised in that** the n-doping start value (D_{A1}) is at most 1·10^{1G} cm⁻³ or at most 1·10¹⁵ cm⁻³ or at most 5·10¹⁴ cm⁻³.

3. Gas phase epitaxy method according to one of the preceding claims, **characterised in that** the p-doping target value (D_{Z}) is at most 5·10¹⁵ cm⁻³ or at most 1·10¹⁵ cm⁻³.

4. Gas phase epitaxy method according to any one of the preceding claims, **characterised in that** after attainment of the p-doping target value (D_{Z}) there is further growth over a growth height (x) of at least 10 µm with the settings for the p-doping target value (D_{Z}).

5. Gas phase epitaxy method according to any one of the preceding claims, **characterised in that** after attainment of the p-doping target value (D_{Z}) a second p-doping target value (D_{Z2}) is set by changing the third mass flow (M_{Dot}) and/or by changing the ratio between the first and second mass flows, wherein the second p-doping target value (D_{Z2}) is greater than the p-doping target value (D_{Z}).

6. Gas phase epitaxy method according to any one of the preceding claims, **characterised in that** the growth height (x) of the transitional region layer (ÜB) is at least 30 µm or at least 60 µm.

7. Gas phase epitaxy method according to any one of the preceding claims, **characterised in that** the doping (D) is changed across the transitional region layer (ÜB) in steps of at most 1·10¹³ cm⁻³ over 5 µm.

8. Gas phase epitaxy method according to any one of the preceding claims, **characterised in that** the doping (D) is changed across the transitional region layer (ÜB) in at least four steps.

9. Gas phase epitaxy method according to any one of the preceding claims, **characterised in that** after attainment of the n-doping start value (D_{A1}) and before growth of the transitional region layer (ÜB) the n-doping start value (D_{A1}) is abruptly lowered by reduction of the third mass flow (M_{Dot}) in the epitaxy gas flow (F) to a second n-doping start value (D_{A2}) or is abruptly set to a p-doping start value (D_{A2*}) of at most 1•10¹⁵ cm⁻³ or at most 5·10¹⁴ cm⁻³.

10. Gas phase epitaxy method according to any one of the preceding claims, **characterised in that** the third precursor is monosilane.

11. Gas phase epitaxy method according to any one of the preceding claims, **characterised in that** the element of the III main group is gallium and the element of the V main group is arsenic.

12. Gas phase epitaxy method according to any one of the preceding claims, **characterised in that** after attainment of the doping target value (D_{Z}) over a growth height a second p-doping target value (D_{Z2}) is set by abrupt change of the third mass flow and/or by abrupt change of the ratio of the first mass flow to the second mass flow, wherein the second p-doping target value (D_{Z2}) is greater than the n-doping target value (D_{Z}).

## Revendications

1. Procédé épitaxial en phase gazeuse, comprenant :
- une étape de croissance d'une couche III-V présentant un profil de dopage évoluant d'un dopage n à un dopage p sur une surface d'un substrat (S) ou d'une couche précédente à l'intérieur d'une chambre de réaction (K) à partir de la phase gazeuse d'un écoulement de gaz épitaxial (F) comprenant un gaz porteur, dans lequel le procédé comprend l'utilisation d'au moins un premier précurseur pour un premier élément du groupe principal III ainsi que l'utilisation d'au moins un deuxième précurseur pour un premier élément du groupe principal V, dans lequel
- lorsqu'une première hauteur de croissance (xₜ) est atteinte, une valeur initiale de dopage n (D_{A1}) est réglée par l'intermédiaire d'un rapport conduisant à un dopage p d'un premier débit massique du premier précurseur à un deuxième débit massique du deuxième précurseur dans l'écoulement de gaz épitaxial (F) et en ajoutant un troisième débit massique (M_{Dot}) d'un troisième précurseur pour un dopant n à l'écoulement de gaz épitaxial (F), et dans lequel
- le troisième débit massique (M_{Dot}) et/ou le rapport entre le premier débit massique et le deuxième débit massique est ensuite modifié en escalier ou de façon continue sur une couche de région de transition (ÜB) avec une hauteur de croissance (x) d'au moins 10 µm jusqu'à l'obtention d'une valeur cible de dopage p (Dz).

2. Procédé épitaxial en phase gazeuse selon la revendication 1, **caractérisé en ce que** la valeur initiale de dopage n (D_{A1}) est au plus égale à 1•10¹⁶ cm⁻³ ou au plus égale à 1•10¹⁵ cm⁻³ ou au plus égale à 5•10¹⁴ cm⁻³.

3. Procédé épitaxial en phase gazeuse selon l'une quelconque des revendications précédentes, **caractérisé en ce que** la valeur cible de dopage p (D_{Z}) est au plus égale à 5•10¹⁵ cm⁻³ ou au plus égale à 1•10¹⁵ cm⁻³.

4. Procédé épitaxial en phase gazeuse selon l'une quelconque des revendications précédentes, **caractérisé en ce que**, une fois que la valeur cible de dopage p (D_{z}) a été atteinte, une étape de croissance supplémentaire est exécutée sur une hauteur de croissance (x) d'au moins 10 µm en utilisant les réglages définis pour la valeur cible de dopage p (D_{z}).

5. Procédé épitaxial en phase gazeuse selon l'une quelconque des revendications précédentes, **caractérisé en ce que**, une fois que la valeur cible de dopage p (D_{z}) a été atteinte, une deuxième valeur cible de dopage p (D_{z2}) est définie en modifiant le troisième débit massique (M_{Dot}) et/ou en modifiant le rapport entre le premier débit massique et le deuxième débit massique, dans lequel la deuxième valeur cible de dopage p (D_{z2}) est supérieure à la valeur cible de dopage p (D_{z}).

6. Procédé épitaxial en phase gazeuse selon l'une quelconque des revendications précédentes, **caractérisé en ce que** la hauteur de croissance (x) de la couche de région de transition (ÜB) est égale à au moins 30 µm ou à au moins 60 µm.

7. Procédé épitaxial en phase gazeuse selon l'une quelconque des revendications précédentes, **caractérisé en ce que** le dopage (D) sur la couche de région de transition (ÜB) est modifié au plus à 1•10¹³ cm⁻³ sur 5 µm.

8. Procédé épitaxial en phase gazeuse selon l'une quelconque des revendications précédentes, **caractérisé en ce que** le dopage (D) est modifié par la couche de région de transition (ÜB) en au moins quatre étapes.

9. Procédé épitaxial en phase gazeuse selon l'une quelconque des revendications précédentes, **caractérisé en ce que**, une fois que la valeur initiale de dopage n (D_{A1}) a été atteinte, et avant la croissance de la couche de région de transition (ÜB), la valeur initiale de dopage n (D_{A1}) est brusquement abaissée à une deuxième valeur initiale de dopage n (D_{A2}) en réduisant le troisième débit massique (M_{Dot}) dans le flux de gaz épitaxial (F) ou est brusquement réglée sur une valeur initiale de dopage p (D_{A2*}) d'au plus 1•10¹⁵ cm⁻³ ou d'au plus 5•10¹⁴ cm⁻³.

10. Procédé épitaxial en phase gazeuse selon l'une quelconque des revendications précédentes, **caractérisé en ce que** le troisième précurseur est le monosilane.

11. Procédé épitaxial en phase gazeuse selon l'une quelconque des revendications précédentes, **caractérisé en ce que** l'élément du groupe principal III est le gallium et l'élément du groupe principal V est l'arsenic.

12. Procédé épitaxial en phase gazeuse selon l'une quelconque des revendications précédentes, **caractérisé en ce que**, une fois que la valeur cible de dopage (D_{Z}) a été atteinte sur une hauteur de croissance, une deuxième valeur cible de dopage p (D_{z2}) est réglée en modifiant brusquement le troisième débit massique et/ou en modifiant brusquement le rapport entre le premier débit massique et le deuxième débit massique, dans lequel la deuxième valeur cible de dopage p (D_{z2}) est supérieure à la valeur cible de dopage n (D_{Z}).
